# EUROPEAN PATENT SPECIFICATION

(11) **EP 1 284 499 B1**
(45) Date of publication and mention of the grant of the patent: **17.10.2012**
(21) Application number: 02255732.6
(22) Date of filing: 16.08.2002
(51) Int. Cl.: H01L 21/66, H01L 23/544, H01L 21/8244, H01L 27/11

(54) **Semiconductor wafer for in-process testing an integrated circuit and corresponding manufacturing method**
Halbleiterwafer für das Testen eines integrierten Schaltkreises während der Herstellung und entsprechendes Herstellungsverfahren
Plaquette semiconductrice pour tester un circuit intégré pendant la fabrication et procédé de fabrication correspondant

(30) Priority: 16.08.2001 US 312352 P; 16.07.2002 US 195527
(43) Date of publication of application: 19.02.2003
(73) Proprietor: Broadcom Corporation, Irvine, CA 92617 (US)
(72) Inventor: Bhattacharya, Surya, Irvine, California 92606 (US); Chen, Ming, Newport Coast, California 92657 (US); Shiau, Guang-Jye, Irvine California 92612 (US); Tsau, Liming, Irvine, California 92606 (US); Chen, Henry, Irvine, Califronia 92606 (US); Kistler, Neal, Monarch Beach, California 92629 (US); Liu, Yi, Union City, California 94587 (US); Huang, Tzu-Hsin, San Jose, California 95120 (US)
(74) Representative: Jehle, Volker Armin

(56) References cited:
- US-A- 5 485 095
- US-A- 5 523 252
- US-A- 5 872 018
- US-A- 5 903 489
- US-B1- 6 194 739
- PATENT ABSTRACTS OF JAPAN vol. 2000, no. 06, 22 September 2000 (2000-09-22) & JP 2000 068346 A (NEC CORP), 3 March 2000 (2000-03-03) & US 2001/035762 A1 (SHIDA AKIRA) 1 November 2001 (2001-11-01)

## Description

### BACKGROUND OF THE INVENTION

### Field of the Invention

The present invention relates to semiconductor devices and, in particular, to in-process electrical testing of integrated circuit (IC) components and process control monitors (PCMs).

### Background Art

Semiconductor integrated circuits (ICs) are formed on substrates, such as silicon wafers, and typically comprise a variety of basic electrical components, such as transistors, resistors, capacitors, and the like. The fabricated components are then interconnected through deposited metal layers, or the like, to form logic or other functions. The various ICs formed on the wafer are typically arranged in a grid pattern and are thus separated by vertical and horizontal scribe areas, also called "streets." Once the wafer is completely processed, it is cut up (diced) into the individual chips (die). Each die is mounted in a package and the terminals of the die are connected to the package terminals through a wire bonding operation. It is desirable to verify that such integrated basic components are fabricated according to a design specification and have certain properties or values, e.g., a specified gain, resistance, capacitance, etc. An individual component cannot readily be tested, however, once integrated into a circuit,

In lieu of testing the integrated components (i.e., the components that are part of the ICs on the wafer), "stand-alone" copies of such basic components are tested. The stand-alone copies are fabricated in some location of the surface of the wafer not occupied by the ICs formed on the wafer, e.g., the scribe areas of the wafer. Such stand-alone copies or target components have properties or values of gain, resistance, and the like that are representative of such properties of their IC counterparts since they are fabricated using the same process. As such, it may be assumed that the parameters measured for the target components are similar to those of the non-tested integrated components, and it is therefore appropriate to apply the test results for the target components to the integrated components. Such a quality control methodology is referred to as "in-process electrical testing."

During in-process electrical testing, a signal source and measurement device, usually external, are electrically connected to the stand-alone target component to be tested, or DUT (device under test). Electrical connection is typically effected via microprobes between the DUT and the measurement device. Various measurement device systems are commercially available.

On the wafer, the target component is electrically connected to pads. Microprobes are used to contact the pads, thereby electrically connecting the signal source and the measurement device to the target component. The measurement device is typically used to measure various response or performance parameters of the target component, i.e., parameters that characterize the response or performance of the target component.

The pads and the target component, collectively, form a "process control monitor" (PCM) or "device monitor," sometimes referred to as a "tester", PCMs are commonly used to monitor the quality of wafer processing in IC manufacturing. *See* U.S. Patent Numbers 5,523,252 and 6,194,739B1 for descriptions of PCMs and their associated pads. PCMs are incorporated typically in the scribe area between two adjacent dice on a wafer. Modern CMOS (complementary metal oxide semiconductor) IC chips incorporate a significant amount of on-chip SRAMs (static random access memories). The embedded SRAMs typically use smaller design rules than the logic CMOS process used to create the circuits in which the SRAMs are embedded.

Therefore, the PCM testline used to monitor the logic CMOS process is not ideally suited for logic-embedded SRAM ICs. What is needed is a PCM testline designed exclusively for logic-embedded SRAMs.

US-A-5 903 489 addresses a semiconductor memory device capable to suppress the increase of the chip area of the product chip caused by dust of conductive materials generated when a chemical-mechanical polishing (CMP) technique is employed for planarization of the semiconductor devices arranged on a wafer. The CMP technique tends to expose the interconnect layers in the monitoring patterns formed on the scribe area and raises the problem of dust due to the peel- off of the conductive materials, especially in the structure of the DRAM wherein the memory cell area is higher than the peripheral area. The teaching of D1 provides a semiconductor memory device comprising a memory cell area including a plurality of memory cells, a peripheral area including a peripheral circuit for controlling the memory cells, the peripheral area including a scribe area at an outer periphery thereof. A first monitoring pattern is disposed in the scribe area, having a level substantially equal to a level of the peripheral circuit, and a second monitoring pattern disposed in an area other than the scribe area, the second monitoring pattern having a level substantially equal to a level of the memory cells. Since the second monitoring pattern having a structure similar to that of the memory cell is disposed in an area other than the scribe area, the CMP process or polyimide removing process for the scribe area does not generate dust of conductive materials from the first monitoring pattern which has a level substantially equal to the level of the peripheral area.

US-A-5 872 018 describes a method for designing testlines suitable for DRAM chips and other integrated circuits (ICs) and teaches the use of product specific test structures for process monitoring of sub-micron DRAM integrated circuits.

US-B1-6 194 739 also aims to reduce the amount of wafer surface sacrificed in conjunction with the use of testers, such as pads and target components forming a process monitor or device monitor, and to improve the accuracy of such measurements for a given size tester. According to US-B1-6 194 739, a wafer configured for in-process testing of electrical components has a plurality of dies disposed on the wafer, wherein adjacent dies are separated from one another by streets. An in-line device monitor having a first port, a second port, and a device-under-test substantially in line with one another is placed within a street, where the device-under-test is between the first and second ports and electrically coupled to the first and second ports.

US-A-5 485 095 is addressed to a need for a more sensitive test circuit and test method for signaling possible out-of-spec resistance shifts, or other type of defect, in a current carrying structure of an integrated circuit. In a first aspect US-A-5 485 095 proposes a fabrication test circuit for signaling possible out-of-spec resistance in a current carrying structure of an associated integrated circuit. The fabrication test circuit includes a plurality of monitor structures electrically connected in parallel. Each monitor structure has an associated test structure and threshold sensitive device. Each test structure is predesigned relative to the current carrying structure of the integrated circuit such that an out-of-spec resistance in the test structure signals a possible out-of-spec resistance in the current carrying structure. The threshold sensitive device of each monitor structure outputs a fail signal when a resistance proportional signal from the associated test structure exceeds a predefined level, the fail signal being representative of out-of-spec resistance in the associated test structure and possible out-of-spec resistance in the current carrying structure of the integrated circuit. Monitor means are provided for monitoring the plurality of monitor structures for a fail signal output from at least one monitor structure.

### BRIEF SUMMARY OF THE INVENTION

The present invention is directed to a method and wafer as defined by the independent claims. A semiconductor wafer is configured for in-process testing of integrated circuitry fabricated thereon. At least two die are separated by a scribe area, and each of the die has at least one complementary metal oxide silicon (CMOS) static random access memory (SRAM) array embedded therein among mixed-signal CMOS circuitry. The mixed-signal CMOS circuitry includes devices with larger feature sizes compared to similar devices of the embedded SRAM array. A first process control monitor (PCM) testline is included, which has a first layout corresponding to the mixed-signal CMOS circuitry. Additionally, a second PCM testline is included, which has a second layout corresponding to the embedded SRAM arrays. The first and second PCM testlines are formed in the scribe area.

In a preferred embodiment, the second PCM testline comprises at least one 6-transistor memory cell.

In other embodiments, the second PCM testline comprises at least one decoder, and/or at least one sense amplifier, and/or at least one data output circuit.

The second PCM testline comprises facsimiles of embedded SRAM array devices located at different locations within the embedded SRAM array, thereby permitting in-process testing to evaluate process variations that are location specific.

The second PCM testline comprises facsimiles of embedded SRAM array devices located at different locations within the embedded SRAM array, thereby permitting in-process testing to track across-die variations of critical dimensions.

The second PCM testline comprises facsimiles of embedded SRAM array devices located at different locations within the embedded SRAM array, thereby permitting in-process testing to track across-die alignment variations.

The second PCM testline comprises facsimiles of embedded SRAM array devices located at different locations within the embedded SRAM array, thereby permitting in-process testing to track across-wafer variations of critical dimensions.

The second PCM testline comprises facsimiles of embedded SRAM array devices located at different locations within the embedded SRAM array, thereby permitting in-process testing to track across-wafer alignment variations,

These and other objects, advantages and features will become readily apparent in view of the following detailed description of the invention.

### BRIEF DESCRIPTION OF THE FIGURES

The features and advantages of the present invention will become more apparent from the detailed description set forth below when taken in conjunction with the drawings in which like reference numbers indicate identical or functionally similar elements. Additionally, the left most digit of a reference number identifies the drawing in which the reference number first appears,

FIG. 1 shows a conventional prior art wafer having a plurality of dies arranged thereon;

FIG. 2 is an enlarged view of a region of the wafer of FIG. 1, showing horizontal and vertical streets located between dies;

FIG. 3 shows an array of like devices that may experience different optical effects during photolithograph; and

FIG. 4 shows SRAM PCMs, in accordance with an embodiment of the present invention.

### DETAILED DESCRIPTION OF THE INVENTION

The preferred embodiment of the present invention will now be discussed in detail. While specific features, configurations and arrangements are discussed, it should be understood that this is done for illustration purposes only. Indeed, for the sake of brevity, conventional electronics, manufacturing of CMOS logic and CMOS SRAMs, and other functional aspects of the method/apparatus (and components of the individual operating components of the apparatus) may not be described in detail herein. Furthermore, for purposes of brevity, the invention is frequently described herein as pertaining to SRAMs for use in electrical or electronic systems. It should be appreciated that many other manufacturing techniques could be used to create the SRAMs described herein, and that the techniques described herein could be used in connection with other devices. Moreover, it should be understood that the spatial descriptions (e.g., "next to", "above", "below", "up", "down", etc.) made herein are for purposes of illustration only.

Moreover, the terms chip, integrated circuit, monolithic device, semiconductor device and microelectronic device are often used interchangeably in this field. The present invention is applicable to all of the above as they are generally understood in the field.

The terms pins, pads and leads refer to input and/or output terminals of a connector, device, chip, printed circuit, or the like, which are used to provide electrical connection to one or more connectors, devices, chips, printed circuits, or the like.

The terms metal line, trace, wire, conductor, signal path and signalling medium are all related. These related terms are generally interchangeable and appear in order from most specific to most general. In this field, metal lines are sometimes referred to as traces, wires, lines, interconnect or simply metal. Metal lines, generally aluminum (Al) or an alloy of Al and copper (Cu), are conductors which provide signal paths for coupling, or interconnecting, electrical circuitry. Conductors other than metal are available in microelectronic devices. Materials such as doped polysilicon, doped single-crystal silicon (often referred to simply as diffusion, regardless of whether such doping is achieved by thermal diffusion or ion implantation), titanium (Ti), molybdenum (Mo), or refractory metal silicides are examples of other conductors. Signalling medium is the most general term and encompasses the others.

As discussed below, the following sections more fully describe the present invention.

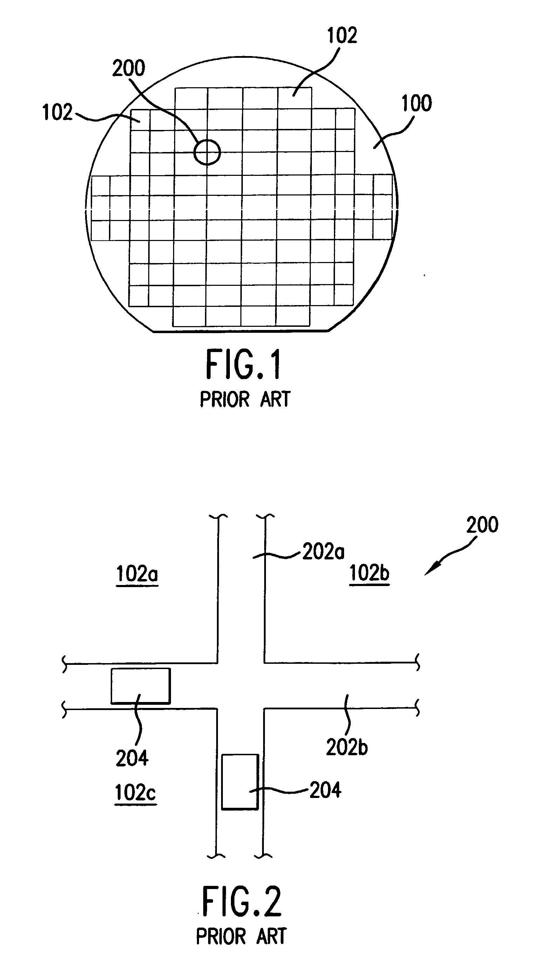

Before describing the present invention, it is useful to discuss prior art wafers and the manner in which PCMs are arranged thereon for in-process electrical testing. Referring now to FIG. 1, there is shown a conventional wafer 100 and a plurality of dies 102 formed thereon. The dies 102 are discrete regions of the wafer at which circuitry (the IC) is patterned. All dies resident on a wafer may contain the same circuitry, such as is typical for mass production of a particular IC, or each die in a plurality of such dies disposed on a single wafer may have a different circuit configuration from other dies on the wafer. Typically, the wafer is diced to separate the dies 102 for use. When separated, the individual dies are typically referred to as an IC or chip.

Referring now to FIG. 2, there is shown an enlarged view of region 200 of wafer 100 of FIG. 1. Adjacent dies, such as adjacent dies 102a and 102b, and adjacent dies 102a and 102c, are separated by respective vertical and horizontal scribe areas (also called streets) 202a, 202b. PCMs or testers 204 operable to test various stand-alone electrical components, counterparts of which stand-alone components are incorporated within the circuits comprising any of the dies 102 on wafer 100, are located in the scribe areas between such dies, such as the scribe areas 202a, 202b.

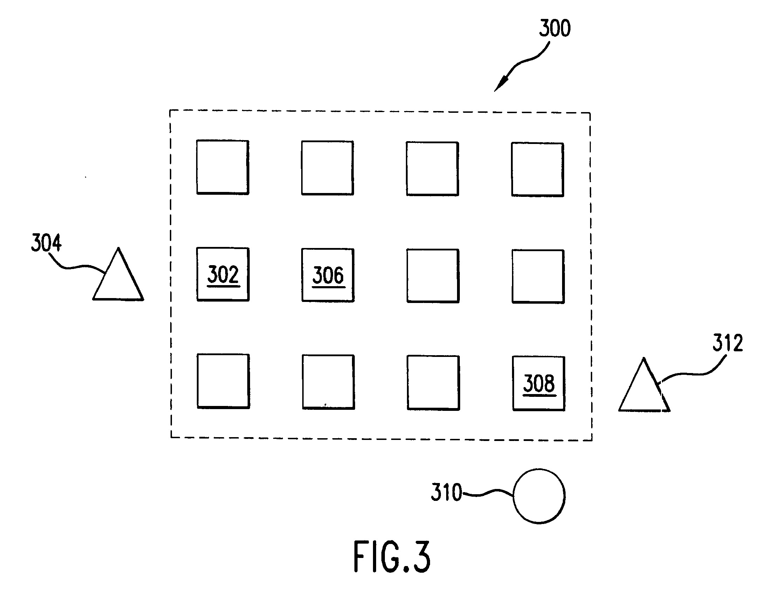

As illustrated in FIG. 3, the inventors have observed that devices at different locations in an array of like devices 300 may experience different optical effects during photolithograph. For example, an edge device 302 is not surrounded on all four sides by similar devices, but may be adjacent to a different device 304 on one side, and a like device 306 on the other side. Similarly, a comer device 308 may be adjacent to one or more different device types 310 and 312. Thus, edge and corner devices can be exposed to optical effects during photolithography that devices in the center of an array of common devices do not experience during processing. Such process variations can impact operational characteristics of the variously positioned devices (i.e., how the circuits behave).

This problem is exasperated in circuits comprising embedded memory. For example, many contemporary circuit designs, such as mixed (analog and digital) signal circuits operating at radio frequencies of 2 GHz (gigahertz) and above, require CMOS SRAM memory arrays. Such SRAM memory arrays are often laid-out (or "embedded") at various, non-symmetric locations of the circuit. Thus, edge and comer memory cells of each embedded SRAM memory array are often located adjacent different devices or components.

The inventors have observed that embedding of SRAM memory arrays can cause operating characteristics of the center, edge, and corner memory cells to vary. Additionally, the inventors have observed that memory array edge and corner cells fail more often than middle cells. This variation of operating characteristics between cells located at different regions of an array and increased failure rates of edge and comer cells may be attributable to optical effects during photolithography. Based on these observations, the inventors have developed a new in-process electrical testing technique to measure and compensate for such variations,

Because the SRAM memory arrays are embedded, they are not provided with separate pinouts. Thus, direct in-process testing is of the embedded SRAM memory arrays is not possible Adding pinouts for testing embedded SRAM memory arrays is not practical.

For the case of a 6-transistor SRAM, for example, it is desirable to monitor the two pull-up PMOS transistors, two pull-down transistors, and the two pass-gates. In addition, it is desirable to monitor junction leakage and gate oxide leakage in the SRAM array. Several conventional an SRAM cell circuits would be apparent to a person skilled in the art.

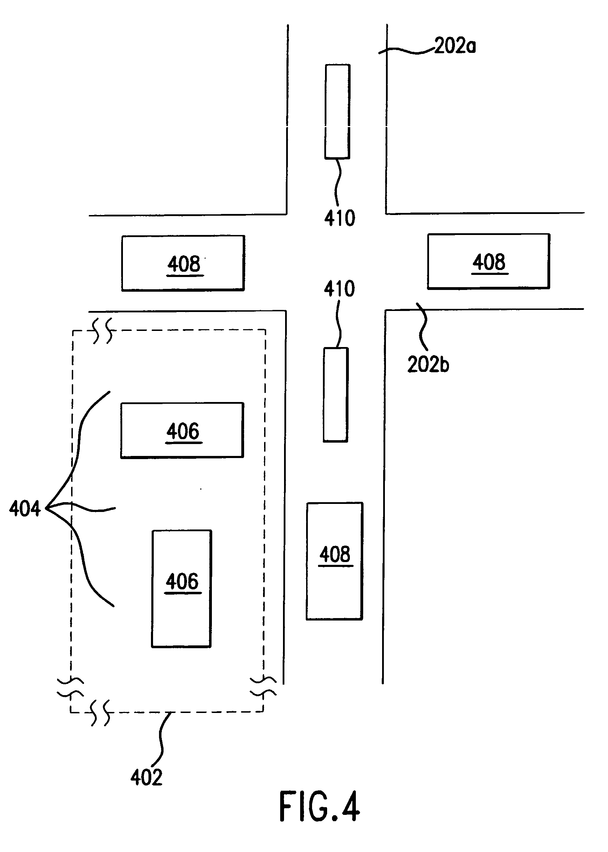

FIG. 4 illustrates the scribe areas -202a and 202b discussed above. A exemplary die 402 comprises standard CMOS logic 404 in which SRAM memory arrays 406 are embedded. The standard (e.g., mixed-signal) CMOS logic circuitry 404 comprises devices with larger feature sizes compared to similar devices of the embedded SRAM memory arrays 406.

SRAM PCM testlines 408 according to the present invention comprise transistors that are laid-out in a manner that is identical to the layout of the on-chip SRAM memory arrays 406. However, independent access is provided to the terminals of the individual transistors (not shown). PCMs 410 corresponding to the standard CMOS logic 404 are also formed as part of the testlines. The PCMs 408 and 410 can be arranged in the scribe areas in many different patterns. For example, PCMs 408 can be formed in the vertical scribe areas and PCMs 410 can be formed in the horizontal scribe areas, or vice versa. PCMs 408 and 410 can be formed in alternating patterns in both the vertical horizontal scribe areas. Alternatively, PCMs 408 and 410 can be formed in any application specific manner in accordance with the teaching herein, as would be apparent to a person skilled in the relevant art.

To obtain individual connection to the SRAM memory transistors, it is important not to alter the layout of the SRAM memory cell up to and including the contacts to the transistors. To mimic the layout of an SRAM array 406, a smaller array (called a mini-array) of SRAM cells are used in the testline 408. In a preferred embodiment, Metal-1 connections are made to independently access the individual NMOS and PMOS transistors, respectively. Thus, basic parameters such as cell current can be monitored in production. Typically, the memory cell at the edge or the corner of the memory array sees a different layout environment compared to a memory cell in the middle of the array. The SRAM testline of the present invention includes transistors from memory , a memory cell, an edge and a corner of the memory array to monitor process variations. Based on such testing using the techniques of the present invention, layout modifications, process modifications, or combinations thereof can be made on subsequent design and tape-out iterations to compensate for such process variations.

In advanced CMOS technology, non-negligible across-die and across-wafer variation of critical dimensions and alignment occurs. To monitor the impact of such variation, the testline of the present invetion is designed to include variations to dimensions of the (a) active region - the channel of the transistor, (b) gate length of the transistor, and (c) size of the contacts. The magnitude of the variations is determined by the extent of across-die uniformity that the process technology can provide, as would be apparent to a person skilled in the relevant art.

The SRAM PCM testlines 408 include a speed path having address loading, address decoding, data sensing, and data output circuits, and the like to facilitate monitoring of the speed path in the embedded SRAM. More specfically, to monitor the junction leakage of P+ to Nwell, or N+ to Psubstrate, a test memory array is generated with all P+ nodes connected in parallel using metal interconnect to a terminal, and similarly all N+ nodes to another terminal. Such a test device can be used to monitor the extent of junction leakage in a SRAM array in production. Also, across-wafer variation of all transistor and junction parameters can be monitored.

In yet another testline embodiment to monitor the cycle time of a memory, which is the speed at which data can be accessed from the memory, a full access path is placed in the SRAM testline. This consists of loading of the address on the latches, subsequent decoding and data access and data output. The data access path can be monitored as a delay chain or as a ring oscillator. Such a test circuit provides a vehicle to monitor the memory performance. Other test circuits will become apparent to those persons skilled in the art in view of the teachings of the present invention.

In addition, the testline can include a sensitive sense amplifier so that the actual sensing circuit of the SRAM 406 can be monitored for manufacturing variations.

Prior art typically uses a standard CMOS logic testline to monitor process quality. Such testlines do not provide accurate information about how process variations affect SRAM performance. In addition, with prior art critical dimension and overlay variations are not included.

The advantages of the proposed testline is that it enables regular accurate monitoring of across-die variation of device parameters associated with a SRAM array and thus reduce yield improvement cycle.

While various embodiments of the present invention have been described above, it should be understood that they have been presented by way of example, and not limitation. It will be apparent to persons skilled in the relevant art that various changes in form and detail can be made therein without departing from the scope of the invention as defined in the claim(s). Among other reasons, this is true in light of (later) developing technology and terms within the relevant art(s). Thus the present invention should not be limited by any of the above-described exemplary embodiments, but should be defined only in accordance with the following claims.

## Claims

1. A semiconductor wafer (100) configured for in-process testing of integrated circuitry fabricated thereon, comprising:
at least two dies (102a, 102b, 102c, 102d) separated by a scribe area (202a, 202b), each of said die (102a, 102b, 102c, 102d) having at least one complementary metal oxide silicon (CMOS) static random access memory (SRAM) array (406) having an SRAM layout embedded therein among mixed-signal CMOS circuitry (404), said mixed-signal CMOS circuitry (404) having devices with larger feature sizes compared to similar devices of said embedded SRAM array (406);
a first process control monitor (PCM) testline (410) having a first layout corresponding to said mixed-signal CMOS circuitry (404);
a second PCM testline (408) having a second layout comprising transistors laid-out in a manner identical to the layout of the embedded SRAM memory array (406) forming a smaller array of SRAM cells that can be used to mimic the layout of said embedded SRAM memory array (406);
said second PCM testline (408) including transistors from memory a memory cell, an edge and a corner of said embedded SRAM memory array (406) to monitor process variations;
wherein independent access is provided to the terminals of said transistors;
said first and second PCM testlines (408, 410) are formed in said scribe area (202a, 202b);
said second PCM testline (408) comprises facsimiles of embedded SRAM array devices located at different locations within said embedded SRAM array (406); and
said second PCM testline (408) including a speed path having address loading, address decoding, data sensing, data output circuits to facilitate monitoring of the speed path in said embedded SRAM array (406).

2. The semiconductor wafer (100) according to claim 1, wherein said second PCM testline (408) comprises at least one 6-transistor memory cell.

3. The semiconductor wafer (100) according to claim 1, wherein said second PCM testline (408) comprises at least one decoder.

4. The semiconductor wafer (100) according to claim 1, wherein said second PCM testline (408) comprises at least one sense amplifier.

5. The semiconductor wafer (100) according to claim 1, wherein said second PCM testline (408) comprises at least one data output circuit.

6. A method for manufacturing an integrated circuitry fabricated on a semiconductor wafer (100) configured by in-process testing, comprising the steps of:
forming at least two die (102a, 102b, 102c, 102d) separated by a scribe area (202a, 202b), each of said die (102a, 102b, 102c, 102d) having at least one complementary metal oxide silicon (CMOS) static random access memory (SRAM) array (406) having an SRAM layout embedded therein among mixed-signal CMOS circuitry (404), said mixed-signal CMOS circuitry (404) having devices with larger feature sizes compared to similar devices of said embedded SRAM array (406);
forming a first process control monitor (PCM) testline (410) having a first layout corresponding to said mixed-signal CMOS circuitry (404);
forming a second PCM testline (408) having a second layout comprising transistors laid-out in a manner identical to the layout of the embedded SRAM memory array (406) to provide a smaller array of SRAM cells that can be used to mimic the layout of said embedded SRAM memory array (406);
forming said second PCM testline (408) to include transistors from memory a memory cell, an edge and a corner of said embedded SRAM memory array (406) to monitor process variations;
providing independent access to the terminals of said transistors;
wherein said first and second PCM testlines (408, 410) are formed in said scribe area (202a, 202b);
the step of forming said second PCM testline (408) comprises forming facsimiles of embedded SRAM array devices located at different locations within said embedded SRAM array (406); and
said second PCM testline (408) including a speed path having address loading, address decoding, data sensing, data output circuits to facilitate monitoring of the speed path in said embedded SRAM array (406).

7. The method according to claim 6, wherein the step of forming said second PCM testline (408) comprises forming at least one decoder.

8. The method according to claim 6, wherein the step of forming said second PCM testline (408) comprises forming at least one sense amplifier.

9. The method according to claim 6, wherein the step of forming said second PCM testline (408) comprises forming at least one data output circuit.

10. The Method according to claim 6, wherein said second PCM testline (408) comprises at least one 6-transistor memory cell.

## Patentansprüche

1. Halbleiter-Wafer (100), der zur Fertigungsprüfung darauf hergestellter integrierter Schaltung konfiguriert ist, mit:
wenigstens zwei Chips (1 02a, 102b, 102c, 102d), die durch einen Ritzbereich (202a, 202b) getrennt sind, wobei jeder Chip (1 02a, 102b, 102c, 102d) wenigstens einen Complementary Metal Oxide Silicon (CMOS) Static Random Access Memory (SRAM) Array (406) mit einem darin eingebetteten SRAM-Layout zwischen Mischsignal-CMOS-Schaltung (404) aufweist, wobei die Mischsignal-CMOS-Schaltung (404) im Vergleich zu ähnlichen Vorrichtungen des eingebetteten SRAM-Arrays (406) Vorrichtungen mit größeren Merkmalsgrößen hat;
einer ersten Prozesssteuerungsüberwachungs- (process control monitor; PCM) -Prüfleitung (410) mit einem ersten Layout, das der Mischsignal-CMOS-Schaltung (404) entspricht;
einer zweiten PCM-Prüfleitung (408) mit einem zweiten Layout mit Transistoren, die in einer zu dem Layout der eingebetteten SRAM-Anordnung (406) identischen Art und Weise ausgelegt sind, wodurch ein kleinerer Array von SRAM-Zellen ausgebildet wird, der verwendet werden kann, um das Layout des eingebetteten SRAM-Arrays (406) nachzuahmen;
wobei die zweite PCM-Prüfleitung (408) Transistoren aus dem Speicher, eine Speicherzelle, eine Flanke und eine Ecke des eingebetteten SRAM-Arrays (406) aufweist, um Prozessveränderungen zu überwachen;
wobei unabhängiger Zugriff zu den Endgeräten der Transistoren bereitgestellt wird;
wobei die ersten und zweiten PCM-Prüfleitungen (408, 410) in dem Ritzbereich (202a, 202b) ausgebildet sind;
wobei die zweite PCM-Prüfleitung (408) naturgetreue Nachbildungen eingebetteter SRAM-Array-Vorrichtungen aufweist, die sich an verschiedenen Stellen in dem eingebetteten SRAM-Array (406) befinden; und
wobei die zweite PCM-Prüfleitung (408) einen Geschwindigkeitspfad mit Adressladungs-, Adressdecodierungs-, Datenabtastungs-, Datenausgangsschaltungen aufweist, um das Überwachen des Geschwindigkeitspfads in dem eingebetteten SRAM-Array (406) zu erleichtern.

2. Halbleiter-Wafer (100) nach Anspruch 1, wobei die zweite PCM-Prüfleitung (408) wenigstens eine 6-Tansitor Speicherzelle aufweist.

3. Halbleiter-Wafer (100) nach Anspruch 1, wobei die zweite PCM-Prüfleitung (408) wenigstens einen Decoder aufweist.

4. Halbleiter-Wafer (100) nach Anspruch 1, wobei die zweite PCM-Prüfleitung (408) wenigstens einen Leseverstärker aufweist.

5. Halbleiter-Wafer (100) nach Anspruch 1, wobei die zweite PCM-Prüfleitung (408) wenigstens eine Datenausgangsschaltung aufweist.

6. Verfahren zum Herstellen einer integrierten Schaltung, die auf einem Halbleiter-Wafer (100) hergestellt wird, der zur Fertigungsprüfung konfiguriert ist, wobei das Verfahren die folgenden Schritte umfasst:
Ausbilden von wenigstens zwei Chips (102a, 102b, 102c, 102d), die durch einen Ritzbereich (202a, 202b) getrennt sind, wobei jeder Chip (1 02a, 102b, 102c, 102d) wenigstens einen Complementary Metal Oxide Silicon (CMOS) Static Random Access Memory (SRAM) Array (406) mit einem darin eingebetteten SRAM-Layout zwischen Mischsignal-CMOS-Schaltung (404) aufweist, wobei die Mischsignal-CMOS-Schaltung (404) im Vergleich zu ähnlichen Vorrichtungen des eingebetteten SRAM-Arrays (406) Vorrichtungen mit größeren Merkmalsgrößen hat;
Ausbilden einer ersten Prozesssteuerungsüberwachungs- (process control monitor; PCM) -Prüfleitung (410) mit einem ersten Layout, das der Mischsignal-CMOS-Schaltung (404) entspricht;
Ausbilden einer zweiten PCM-Prüfleitung (408) mit einem zweiten Layout mit Transistoren, die in einer zu dem Layout der eingebetteten SRAM-Anordnung (406) identischen Art und Weise ausgelegt sind, um einen kleineren Array von SRAM-Zellen bereitzustellen, der verwendet werden kann, um das Layout des eingebetteten SRAM-Arrays (406) nachzuahmen;
Ausbilden der zweiten Prüfleitung (408) so, dass sie Transistoren aus dem Speicher, eine Speicherzelle, eine Flanke und eine Ecke des eingebetteten SRAM-Arrays (406) aufweist, um Prozessveränderungen zu überwachen;
Bereitstellen von unabhängigem Zugriff zu den Endgeräten der Transistoren;
wobei die ersten und zweiten PCM-Prüfleitungen (408, 410) in dem Ritzbereich (202a, 202b) ausgebildet sind;
wobei der Schritt des Ausbildens der zweiten PCM-Prüfleitung (408) das Ausbilden naturgetreuer Nachbildungen eingebetteter SRAM-Array-Vorrichtungen umfasst, die sich an verschiedenen Stellen in dem eingebetteten SRAM-Array (406) befinden; und
wobei die zweite PCM-Prüfleitung (408) einen Geschwindigkeitspfad mit Adressladungs-, Adressdecodierungs-, Datenabtastungs-, Datenausgangsschaltungen aufweist, um das Überwachen des Geschwindigkeitspfads in dem eingebetteten SRAM-Array (406) zu erleichtern.

7. Verfahren nach Anspruch 6, wobei der Schritt des Ausbildens der zweiten PCM-Prüfleitung (408) das Ausbilden wenigstens eines Decoders umfasst.

8. Verfahren nach Anspruch 6, wobei der Schritt des Ausbildens der zweiten PCM-Prüfleitung (408) das Ausbilden wenigstens eines Leseverstärkers umfasst.

9. Verfahren nach Anspruch 6, wobei der Schritt des Ausbildens der zweiten PCM-Prüfleitung (408) das Ausbilden wenigstens einer Datenausgangsschaltung umfasst.

10. Verfahren nach Anspruch 6, wobei die zweite PCM-Prüfleitung (408) wenigstens eine 6-Transistor Speicherzelle aufweist.

## Revendications

1. Tranche de semi-conducteur (100) configurée pour des tests en cours de processus de circuits intégrés fabriqués sur celle-ci, comprenant :
au moins deux dés (1 02a, 102b, 102c, 102d) séparés par un chemin de découpe (202a, 202b), chacun desdits dés (1 02a, 102b, 102c, 102d) ayant au moins une matrice (406) de mémoire statique à accès aléatoire (SRAM) au silicium à oxyde de métal complémentaire (CMOS) ayant une topologie de SRAM intégrée dans celle-ci dans un ensemble de circuits CMOS à signal mixte (404), ledit ensemble de circuits CMOS à signal mixte (404) ayant des dispositifs ayant des tailles de caractéristiques plus grandes par rapport à des dispositifs similaires de ladite matrice (406) de SRAM intégrée ;
une première ligne de test (410) de surveillance de commande de processus (PCM) ayant une première topologie correspondant audit ensemble de circuits CMOS à signal mixte (404) ;
une deuxième ligne de test (408) de PCM ayant une deuxième configuration comprenant des transistors disposés d'une manière identique à la topologie de la matrice (406) de mémoire SRAM intégrée formant une matrice plus petite de cellules de SRAM qui peut être utilisée pour imiter la topologie de ladite matrice (406) de mémoire SRAM intégrée ;
ladite deuxième ligne de test (408) de PCM incluant des transistors de la mémoire, une cellule de mémoire, un bord et un angle de ladite matrice (406) de mémoire SRAM intégrée pour surveiller des variations de processus ;
dans lequel un accès indépendant est prévu aux bornes desdits transistors ;
lesdites première et deuxième lignes de test (408, 410) de PCM sont formées dans ledit chemin de découpe (202a, 202b) ;
ladite deuxième ligne de test (408) de PCM comprend des facsimiles de dispositifs de matrice de SRAM intégrée situés en différents emplacements au sein de ladite matrice (406) de SRAM intégrée ; et
ladite deuxième ligne de test (408) de PCM incluant une voie de vitesse ayant des circuits de chargement d'adresses, de décodage d'adresses, de détection de données, de sortie de données pour faciliter la surveillance de la voie de vitesse dans ladite matrice (406) de SRAM intégrée.

2. Tranche de semi-conducteur (100) selon la revendication 1, dans laquelle ladite deuxième ligne de test (408) de PCM comprend au moins une cellule de mémoire à 6 transistors.

3. Tranche de semi-conducteur (100) selon la revendication 1, dans laquelle ladite deuxième ligne de test (408) de PCM comprend au moins un décodeur.

4. Tranche de semi-conducteur (100) selon la revendication 1, dans laquelle ladite deuxième ligne de test (408) de PCM comprend au moins un amplificateur de détection.

5. Tranche de semi-conducteur (100) selon la revendication 1, dans laquelle ladite deuxième ligne de test (408) de PCM comprend au moins un circuit de sortie de données.

6. Procédé de fabrication d'un ensemble de circuits intégrés fabriqué sur une tranche de semi-conducteur (100) configurée par des tests en cours de processus, comprenant les étapes de :
formation d'au moins deux dés (1 02a, 102b, 102c, 102d) séparés par un chemin de découpe (202a, 202b), chacun desdits dés (1 02a, 102b, 102c, 102d) ayant au moins une matrice (406) de mémoire statique à accès aléatoire (SRAM) au silicium à oxyde de métal complémentaire (CMOS) ayant une topologie de SRAM intégrée dans celle-ci dans un ensemble de circuits CMOS à signal mixte (404), ledit ensemble de circuits CMOS à signal mixte (404) ayant des dispositifs ayant des tailles de caractéristiques plus grandes par rapport à des dispositifs similaires de ladite matrice (406) de SRAM intégrée ;
formation d'une première ligne de test (410) de surveillance de commande de processus (PCM) ayant une première topologie correspondant audit ensemble de circuits CMOS à signal mixte (404) ;
formation d'une deuxième ligne de test (408) de PCM ayant une deuxième configuration comprenant des transistors disposés d'une manière identique à la topologie de la matrice (406) de mémoire SRAM intégrée pour former une matrice plus petite de cellules de SRAM qui peut être utilisée pour imiter la topologie de ladite matrice (406) de mémoire SRAM intégrée ;
formation de ladite deuxième ligne de test (408) de PCM pour qu'elle inclue des transistors de la mémoire, une cellule de mémoire, un bord et un angle de ladite matrice (406) de mémoire SRAM intégrée pour surveiller des variations de processus ;
la prévision d'un accès indépendant aux bornes desdits transistors ;
dans lequel lesdites première et deuxième lignes de test (408, 410) de PCM sont formées dans ledit chemin de découpe (202a, 202b) ;
l'étape de formation de ladite deuxième ligne de test (408) de PCM comprend la formation de facsimiles de dispositifs de matrice de SRAM intégrée situés en différents emplacements au sein de ladite matrice (406) de SRAM intégrée ; et
ladite deuxième ligne de test (408) de PCM incluant une voie de vitesse ayant des circuits de chargement d'adresses, de décodage d'adresses, de détection de données, de sortie de données pour faciliter la surveillance de la voie de vitesse dans ladite matrice (406) de SRAM intégrée.

7. Procédé selon la revendication 6, dans lequel l'étape de formation de ladite deuxième ligne de test (408) de PCM comprend la formation d'au moins un décodeur.

8. Procédé selon la revendication 6, dans lequel l'étape de formation de ladite deuxième ligne de test (408) de PCM comprend la formation d'au moins un amplificateur de détection.

9. Procédé selon la revendication 6, dans lequel l'étape de formation de ladite deuxième ligne de test (408) de PCM comprend la formation d'au moins un circuit de sortie de données.

10. Procédé selon la revendication 6, dans lequel ladite deuxième ligne de test (408) de PCM comprend au moins une cellule de mémoire à 6 transistors.
